(19) Europäisches Patentamt
European Patent Office
Office européen des brevets

(11) **EP 4 491 680 A1**

(12) **EUROPEAN PATENT APPLICATION**
published in accordance with Art. 153(4) EPC

(43) Date of publication:
**15.01.2025 Bulletin 2025/03**

(21) Application number: **23788228.7**

(22) Date of filing: **05.04.2023**

(51) International Patent Classification (IPC):
*C09D 5/02* (2006.01)     *C09D 127/12* (2006.01)
*C09D 201/04* (2006.01)     *C09D 7/47* (2018.01)
*C09D 7/61* (2018.01)

(52) Cooperative Patent Classification (CPC):
(C-Sets available)
**H01B 3/44; B32B 15/08; B32B 27/30;**
**C08F 214/262; C09D 5/02; C09D 7/47; C09D 7/61;**
**C09D 7/63; C09D 127/18; H05K 3/285;**
C08F 114/26; C08F 214/26; C08K 3/34;
C08K 2003/385; C08L 2205/025;     (Cont.)

(86) International application number:
**PCT/JP2023/014045**

(87) International publication number:
**WO 2023/199809 (19.10.2023 Gazette 2023/42)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **11.04.2022 JP 2022065116**

(71) Applicant: DAIKIN INDUSTRIES, LTD.
**Osaka-shi, Osaka 530-0001 (JP)**

(72) Inventors:
• UEDA, Yuki
**Osaka-shi, Osaka 530-0001 (JP)**
• YAMASHITA, Ai
**Osaka-shi, Osaka 530-0001 (JP)**
• OKUNO, Shingo
**Osaka-shi, Osaka 530-0001 (JP)**
• YAMAUCHI, Akiyoshi
**Osaka-shi, Osaka 530-0001 (JP)**

(74) Representative: **Goddar, Heinz J.
Boehmert & Boehmert
Anwaltspartnerschaft mbB
Pettenkoferstrasse 22
80336 München (DE)**

(54) **COATING COMPOSITION, INSULATING MATERIAL, AND LAMINATE**

(57) Provided is a coating composition capable of forming a coating film layer, which has low coefficient of linear expansion at low dielectricity, excellent adhesive properties even when the surface of a counterpart material is smooth, and few coating film defects such as cracks and holes. A coating composition comprising 2 or more kinds of fluororesin emulsions, wherein at least 1 kind of the fluororesin, a fluororesin (I), has a number of functional groups of 30 to 1,000 per $10^6$ main-chain carbon atoms, and the coating composition further comprises an anisotropic filler, a surfactant, and a liquid medium.

EP 4 491 680 A1

(52) Cooperative Patent Classification (CPC): (Cont.)
C08L 2205/03; H05K 1/03; H05K 2201/015;
H05K 2201/0209; H05K 2201/0212;
H05K 2201/0323

C-Sets
**C08F 214/262, C08F 216/1408;**
**C09D 127/18, C08L 27/18, C08K 7/00,**
**C08L 71/02;**
C08F 214/26, C08F 214/28

**Description**

Technical Field

The present disclosure relates to a coating composition, an insulating material, and a laminate.

Background Art

An epoxy resin and a polyimide resin have been commonly used as an insulating layer for circuit boards. In recent years, some proposals have been made on a structure in which a high frequency circuit board used in a high frequency range of a tens of gigahertz level has a fluororesin insulating layer formed on a copper foil, from the viewpoint of dielectric characteristics and hygroscopicity.

Patent Literature 1 discloses a dispersion containing a powder of a tetrafluoroethylene polymer containing a unit based on perfluoro(alkyl vinyl ether) or a unit based on hexafluoropropylene, an anisotropic filler having a Mohs hardness of 4 or less, and a liquid dispersion medium.

Patent Literature 2 describes a liquid composition containing a liquid medium and a resin powder having a specific particle size dispersed in the liquid medium, and a powder of polytetrafluoroethylene or an inorganic filler.

Patent Literature 3 discloses a fluororesin composition containing a melt-formable fluororesin and a spherical silica.

Patent Literature 4 discloses a resin composition for a dielectric containing an inorganic substance dispersed in a thermoplastic resin and/or a thermosetting resin, wherein the inorganic substance contains a platelike inorganic particle, which has a material selected from the group consisting of hexagonal boron nitride, aluminum oxide, talc, and mica.

Citation List

Patent Literature

Patent Literature 1: International Publication No. WO 2021/112164
Patent Literature 2: Japanese Patent Laid-Open No. 2021-121675
Patent Literature 3: International Publication No. WO 2020/145133
Patent Literature 4: Japanese Patent Laid-Open No. 2015-40296

Summary of Invention

Technical Problem

The present disclosure aims to provide a coating composition capable of forming a coating film layer, which has low coefficient of linear expansion at low dielectricity, excellent adhesive properties even when the surface of a counterpart material is smooth, and few coating film defects such as cracks and holes.

Solution to Problem

The present disclosure relates to a coating composition containing 2 or more kinds of fluororesin dispersions, wherein

at least 1 kind of the fluororesin, a fluororesin (I), has a number of functional groups of 30 to 1,000 per $10^6$ main-chain carbon atoms, and
the coating composition further contains an anisotropic filler, a surfactant, and a liquid medium.

It is preferable that the functional group contained in the fluororesin (I) is a carbonyl group-containing group.
It is preferable that the carbonyl group-containing group is at least 1 group selected from the group consisting of a carbonyl amide group, a carboxy group, an acyl fluoride group, and a methoxycarbonyl group.
It is preferable that the functional group contained in the fluororesin (I) is present at an end of the polymer main chain.
It is preferable that the fluororesin (I) is a tetrafluoroethylene-hexafluoropropylene copolymer (FEP) or a tetrafluoroethylene-perfluoroalkyl vinyl ether copolymer (PFA).

In the coating composition, at least 1 kind of the fluororesin is preferably a fluororesin (II) having a number of functional groups of less than 30 per $10^6$ main-chain carbon atoms.

The fluororesin (II) is preferably PTFE.

The PTFE preferably has an average particle size of PTFE is 0.1 to 0.5 $\mu$m.

In the coating composition, the content of the PTFE is preferably 50% by mass or more with respect to all fluororesins amount.

The average particle size of the fluororesins is preferably 1/5 or less of an average particle size of the anisotropic filler.

The average particle size of the fluororesins is preferably less than 0.3 $\mu$m.

The anisotropic filler is preferably boron nitride or talc.

The anisotropic filler preferably has an aspect ratio of 15 or more.

In the coating composition, the mass ratio of the anisotropic filler to the total amount of the fluororesins is preferably 5:95 to 60:40.

It is preferable that the surfactant is a non-fluorosurfactant.

It is preferable that the liquid medium contains water.

The present disclosure also relates to an insulating material for a circuit board comprising the coating composition described above.

The present disclosure also relates to a laminate having a coating film layer formed by applying the above-mentioned coating composition onto a substrate.

The substrate may be a metal material.

The metal material may have a surface roughness Rz of 2.0 $\mu$m or less on the surface of the coating film layer side.

The metal is preferably copper.

It is preferable that the laminate is a printed circuit board, a dielectric material for a circuit board, or a laminated circuit board.

Advantageous Effects of Invention

The coating composition of the present disclosure has low coefficient of linear expansion at low dielectricity, excellent adhesive properties even when the surface of a counterpart material is smooth, and further provides good adhesive properties with a copper foil having Rz of 2.0 $\mu$m or less, and can reduce a conductor loss, thereby being capable of providing a circuit board with a low transmission loss.

Description of Embodiments

Hereinafter, the present disclosure will be described.

The coating composition of the present disclosure contains 2 or more kinds of fluororesin dispersions, wherein at least 1 kind of the fluororesin, a fluororesin (I), has a number of functional groups of 30 to 1,000 per $10^6$ main-chain carbon atoms, and the coating composition further contains an anisotropic filler, a surfactant, and a liquid medium.

For examples, the conventional fluorine-containing coating compositions described in Patent Literatures 1 and 2 are obtained by dispersing dried and powdered fluororesins in a liquid medium, and further containing a filler and a surfactant.

On the other hand, the present disclosure uses the fluororesins in the form of an emulsion at the end of polymerization, or in the form of a concentrated emulsion at the end of polymerization. Namely, the fluororesins are not taken out as the powder from the emulsion at the end of polymerization but are used directly as dispersed. In the present disclosure, liquid fluororesins are dispersed and float in the form of fine particles in a liquid dispersion medium.

When the fluororesins are used in the form of the above emulsion, fluororesin fine particles particularly having a small particle size can be stably contained. Thus, fluororesin particles can be densely contained, thereby obtaining a fluororesin-containing coating composition having good properties in the linear expansion, dielectric characteristics, and the like.

Further, the coating film layer formed by applying the coating composition has a good surface appearance with few coating film defects.

Furthermore, the step of drying and powdering the fluororesins is not required, hence preferable from the viewpoint of reducing the number of steps. The polymerization of the fluororesins is not limited, and examples include, solution polymerization, suspension polymerization, emulsion polymerization, and the like.

(Fluororesin (I))

The coating composition contains 2 or more kinds of emulsions containing fluororesins. Of the fluororesins, at least 1 kind of fluororesin, a fluororesin (I), has a number of functional groups of 30 to 1,000 per $10^6$ main-chain carbon atoms.

It should be noted that the functional group used herein means a functional group that causes interaction with the surface of an adherend and contributes to enhancement in adhesive properties. Specifically, it is preferable that the functional groups are those shown in Table 1 below.

The lower limit in the number of functional groups is preferably 50 groups, and further preferably 100 groups. The upper limit in the number of functional groups is more preferably 800 groups, and further preferably 500 groups.

Infrared spectroscopy can be used to identify the kind of functional groups and measure the number of functional groups.

The number of functional groups can be analyzed from an aqueous dispersion of a single fluororesin but can also be analyzed by isolating a fluororesin of interest from a coating material.

The number of functional groups is specifically measured by the following method. First, a tablet is prepared using a fluororesin powder and KBr, and this tablet is analyzed by Fourier-transform infrared spectroscopy to obtain an infrared absorption spectrum of the fluororesin, whereby a difference spectrum from the base spectrum, in which functional groups are completely fluorinated and absent, is obtained. Using the absorption peak of a specific functional group appeared in this difference spectrum, the number of functional groups N per $1 \times 10^6$ carbon atoms in the fluororesin is calculated in accordance with the following formula (A).

$$N = I \times K / t \quad (A)$$

I: Absorbance
K: Correction coefficient
t: Film thickness (mm)

For reference, absorption frequency, molar absorption coefficient, and correction coefficient of the functional groups in the present disclosure are shown in Table 1. The molar absorption coefficients are determined based on FT-IR measurement data of low molecular weight model compounds.

[Table 1]

| Functional group | Absorption frequency (CM$^{-1}$) | Molar absorption coefficient (1/cm/mol) | Correction coefficient | Model compound |
|---|---|---|---|---|
| -COF | 1883 | 600 | 388 | $C_7F_{15}COF$ |
| -COOH free | 1815 | 530 | 439 | $H(CF_2)_6COOH$ |
| -COOH bonded | 1779 | 530 | 439 | $H(CF_2)_6COOH$ |
| -COOCH$_3$ | 1795 | 680 | 342 | $C_7F_{15}COOCH_3$ |
| -CONH$_2$ | 3436 | 506 | 460 | $C_7H_{15}CONH_2$ |
| -CH$_2$OH, -OH | 3648 | 104 | 2236 | $C_7H_{15}CH_2OH$ |
| -CF$_2$H | 3020 | 8.8 | 26485 | $H(CF_2OF_2)_3CH_2OH$ |
| -CF=CF$_2$ | 1795 | 635 | 366 | $CF_2=CF_2$ |

It should be noted that the absorption frequencies of -CH$_2$CF$_2$H, -CH$_2$COF, -CH$_2$COOH, -CH$_2$COOCH$_3$, and -CH$_2$CONH$_2$ are lower in several tens of kayser (cm$^{-1}$) than the absorption frequencies of -CF$_2$H, -COF, -COOH free and -COOH bonded, -COOCH$_3$, and -CONH$_2$ shown respectively in the table.

Accordingly, for example, the number of functional groups of -COF is the total of the number of functional groups determined from the absorption peak of absorption frequency 1883 cm$^{-1}$ caused by -CF$_2$COF and the number of functional groups determined from the absorption peak of absorption frequency 1840 cm$^{-1}$ caused by -CH$_2$COF.

The functional group refers to functional groups present at an end of the main chain or an end of a side chain of the fluororesin (I), and functional groups present in the main chain or a side chain. In the present disclosure, it is preferable that the functional group is present at an end of the polymer main chain. A functional group present at a polymer end can efficiently enhance adhesive properties.

**EP 4 491 680 A1**

The number of functional groups may be the total number of $-CF=CF_2$, $-CF_2H$, $-COF$, $-COOH$, $-COOCH_3$, $-CONH_2$, and $-CH_2OH$.

In the present disclosure, it is preferable that the functional group is carbonyl group-containing groups, and of these it is more preferable that the functional group is at least 1 group selected from the group consisting of carbonyl amide group, carboxy group, acyl fluoride group, and methoxycarbonyl group. Carboxy group and carbonyl amide group are particularly preferable from the viewpoint of imparting adhesive properties.

The functional group is introduced to a fluororesin by, for example, a chain transfer agent or a polymerization initiator used for producing the fluororesin. For example, when alcohol is used as the chain transfer agent, or a peroxide having the $-CH_2OH$ structure is used, $-CH_2OH$ is introduced to an end of the main chain of a fluororesin. Alternatively, the fluororesin to which the functional group is introduced by polymerizing monomers having a functional group may also be acceptable.

The functional groups are preferably introduced to an end of a fluororesin by a chain transfer agent or a polymerization initiator used for producing the fluororesin. Such a structure is preferable in terms of achieving better adhesive properties.

The functional groups, which are introduced to an end of a fluororesin by a chain transfer agent or a polymerization initiator used for producing the fluororesin, may further be reacted to convert to other structures. There is also a method of generating a functional group at an end of the main chain by subjecting a powder of fluororesin to corona treatment.

It is preferable that the fluororesin (I) has a melting point of 190 to 350°C. The melting point is more preferably 200°C or more, further preferably 220°C or more, particularly preferably 280°C or more, and more preferably 330°C or less. The melting point refers to the temperature corresponding to the local maximum value of the heat-of-fusion curve at a temperature increase rate of 10°C/min using a differential scanning calorimeter [DSC].

The fluororesin (I) is preferably a melt-processable fluororesin. Further, it is more preferable from the viewpoint of obtaining excellent electrical characteristics that the fluororesin (I) is at least 1 kind of copolymer selected from the group consisting of a copolymer containing a tetrafluoroethylene unit (TFE unit) and a fluoroalkyl allyl ether or a (per)fluoro(alkyl vinyl ether) unit (PAVE unit) (hereinafter, referred to as TFE/fluoroalkyl allyl ether or PAVE copolymer (or PFA)), and a copolymer containing a TFE unit and a hexafluoropropylene unit (HFP unit) (hereinafter, referred to as TFE/HFP copolymer (or FEP)). Of these, it is particularly preferable to contain the TFE/HFP copolymer (FEP) from the viewpoint of imparting more excellent adhesive properties.

The fluororesin (I) may also use 2 or more kinds of fluororesins in combination.

(Per)fluoro(alkyl vinyl ether) (PAVE) may be fluoroalkyl vinyl ether, or may also be perfluoro(alkyl vinyl ether). In the present disclosure, the "perfluoro(alkyl vinyl ether)" refers to alkyl vinyl ether that does not contain a C-H bond.

PAVE structuring the PAVE unit can be at least 1 kind selected from the group consisting of a monomer represented by Formula (1):

$$CF_2=CFO(CF_2CFY^1O)_p\text{-}(CF_2CF_2CF_2O)_q\text{-}R^f \qquad (1)$$

wherein $Y^1$ represents F or $CF_3$, $R^f$ represents a perfluoroalkyl group having 1 to 5 carbon atoms. p represents an integer of 0 to 5, and q represents an

integer of 0 to 5), and a monomer represented by Formula (2) :

$$CFX=CXOCF_2OR^1 \qquad (2)$$

wherein X, same or different, represents H, F or $CF_3$, $R^1$ is a linear or branched fluoroalkyl group having 1 to 6 carbon atoms and may contain 1 to 2 atoms of at least 1 kind selected from the group consisting of H, Cl, Br and I, or a cyclic fluoroalkyl group having 5 or 6 carbon atoms and may contain 1 to 2 atoms of at least 1 kind selected from the group consisting of H, Cl, Br and I.

Of these, the PAVE is preferably the monomer represented by Formula (1), more preferably at least 1 kind selected from the group consisting of perfluoro(methyl vinyl ether), perfluoro(ethyl vinyl ether) and perfluoro(propyl vinyl ether) (PPVE), and further preferably PPVE.

The content of the PAVE unit in the TFE/PAVE copolymer with respect to all the monomer units is preferably 1.0 to 10% by mass, more preferably 2.0% by mass or more, further preferably 3.5% by mass or more, particularly preferably 4.0% by mass or more, most preferably 5.0% by mass or more, and more preferably 8.0% by mass or less, further preferably 7.0% by mass or less, particularly preferably 6.5% by mass or less, and most preferably 6.0% by mass or less. An amount of the PAVE unit is measured by the $^{19}$F-NMR method. The TFE/PAVE copolymer may be a copolymer consisting only of the TFE unit and the PAVE unit.

When the fluoropolymer (I) is the TFE/PAVE copolymer, the melting point is preferably 280 to 322°C, more preferably 290°C or more, and more preferably 315°C or less.

6

When the fluoropolymer (I) is the TFE/PAVE copolymer, glass transition temperature (Tg) is preferably 70 to 110°C, more preferably 80°C or more, and more preferably 100°C or less. The glass transition temperature is the value obtained by measuring dynamic viscoelasticity.

The TFE/HFP copolymer contains the TFE unit and the HFP unit. The content of the TFE unit in the TFE/HFP copolymer with respect to all the monomer units is preferably 70% by mass or more, more preferably 85% by mass or more, and preferably 99.8% by mass or less, more preferably 99% by mass or less, and further preferably 98% by mass or less.

It is preferable that the TFE/HFP copolymer has a mass ratio of the TFE unit to the HFP unit (TFE/HFP) of 70 to 99/1 to 30 (% by mass). The mass ratio (TFE/HFP) is more preferably 85 to 95/5 to 15 (% by mass).

The TFE/HFP copolymer can further contain a (per)fluoro(alkyl vinyl ether) (PAVE) unit. Examples of the PAVE unit contained in the TFE/HFP copolymer include the same PAVE units as described above. The TFE/PAVE copolymer described above does not contain the HFP unit and thus is different from the TFE/HFP/PAVE copolymer in that respect.

When the TFE/HFP copolymer is a copolymer containing the TFE unit, HFP unit, and PAVE unit (hereinafter, also referred to as "TFE/HFP/PAVE copolymer"), the mass ratio (TFE/HFP/PAVE) is preferably 70 to 99.8/0.1 to 25/0.1 to 25 (% by mass). The mass ratio (TFE/HFP/PAVE) is more preferably 75 to 98/1.0 to 15/1.0 to 10 (% by mass). It is preferable that the TFE/HFP/PAVE copolymer contains 1% by mass or more of the HFP unit and the PAVE unit in total with respect to all the monomer units.

The TFE/HFP/PAVE copolymer preferably contains 250 by mass or less of the HFP unit of all the monomer units. The content of the HFP unit is more preferably 20% by mass or less, further preferably 18% by mass or less, and particularly preferably 15% by mass or less. The content of the HFP unit is preferably 0.1% by mass or more, more preferably 1% by mass or more, and particularly preferably 2% by mass or more. The content of the HFP unit can be measured by the $^{19}$F-NMR method.

The content of the PAVE unit is more preferably 200 by mass or less, and further preferably 10% by mass or less, and particularly preferably 3% by mass or less. The content of the PAVE unit is preferably 0.1% by mass or more, and more preferably 1% by mass or more. The content of the PAVE unit can be measured by the $^{19}$F-NMR method.

The TFE/PAVE copolymer and the TFE/HFP copolymer may further contain another ethylene monomer ($\alpha$) unit. The another ethylene monomer ($\alpha$) unit is not limited as long as it is a monomer unit copolymerizable with TFE, HFP and PAVE, and examples include fluorine-containing ethylene monomers such as vinyl fluoride (VF), vinylidene fluoride (VdF), trifluoroethylene (TrFE), and chlorotrifluoroethylene (CTFE), and non-fluorinated ethylene monomers such as ethylene, propylene and alkyl vinyl ether. The content of the another ethylene monomer ($\alpha$) unit is preferably 0 to 25% by mass, and more preferably 0.1 to 25% by mass.

When the copolymer is a TFE/HFP/PAVE/another ethylene monomer ($\alpha$) copolymer, the mass ratio (TFE/HFP/-PAVE/another ethylene monomer ($\alpha$)) is preferably 70 to 98/0.1 to 25/0.1 to 25/0.1 to 25 (% by mass). It is preferable that the TFE/HFP/PAVE/another ethylene monomer ($\alpha$) copolymer contains 1% by mass or more of monomer units other than the TFE unit in total.

The melting point of the TFE/HFP copolymer is preferably 200 to 322°C, more preferably more than 200°C, and further preferably 220°C or more, and more preferably 300°C or less, and further preferably 280°C or less.

The glass transition temperature (Tg) of the TFE/HFP copolymer is preferably 60 to 110°C, more preferably 65°C or more, and more preferably 100° or less. The glass transition temperature is the value obtained by measuring dynamic viscoelasticity.

The fluororesin (I) can be produced by a conventionally known method of, for example, suitably mixing monomers to be constituent units of the resin and additives such as a polymerization initiator, and performing emulsion polymerization and suspension polymerization. Of these, the fluororesin (I) obtained by the emulsion polymerization is more preferable.

It is preferable that the fluororesin (I) has a value of MFR within a range from 0.5 to 100 when measured at 372°C with a load of 5 kg. Such a range is preferable in terms of easily obtaining the above-mentioned amount of functional groups by end functional groups.

The coating composition of the present disclosure contains the fluororesin (I) and another fluororesin (II) in combination.

The fluororesin (II) is not limited and preferably has the number of functional groups of less than 30 per $10^6$ main-chain carbon atoms. Namely, it is preferable that the fluororesin (II) is different from the fluororesin (I) in terms of the number of functional groups.

A fluororesin with a large number of functional groups exhibits excellent performance in the respect of adhesion but is likely to have insufficient electrical characteristics and heat resistance. For this reason, it is preferable to use a fluororesin with excellent electrical characteristics and heat resistance as the fluororesin (II) in combination. By doing this, a coating layer with excellent coating film properties such as electrical characteristics and heat resistance can be formed.

The fluororesin (II) is not limited as long as it is a fluorine-containing resin, and examples include polytetrafluoroethylene resin (PTFE), PFA, and FEP. Of these, PTFE is particularly preferable. PTFE is further preferable because the TFE homopolymer has soft particles that easily stick, thereby less likely causing cracks. The index of softness is not limited but preferably a shore hardness (D scale) of D65 or less, more preferably D60 or less, and particularly preferably D55 or less.

The PTFE preferably has an average particle size of 0.1 to 0.5 $\mu$m.

The average particle size of the PTFE is the value obtained by diluting the PTFE emulsion 1,000-fold with water, placing a drop of the diluted liquid on an aluminum foil to dry by itself, taking an SEM (scanning electron microscope) image thereof, measuring particle sizes from image data of 50 particles randomly selected using an SEM image analysis software, and calculating an average.

The content of the PTFE with respect to all fluororesins amount is preferably 50% by mass or more. A content of 50% by mass or more imparts sufficient heat resistance and achieves an effect of preventing a coating film from cracking, hence preferable. The content of the PTFE is more preferably 70% by mass or more, and preferably 95% by mass or less.

It is preferable to use PFA and FEP that have the same resin compositions as the fluororesin (I) described above, and have the different number of functional groups from that of the fluororesin (I).

The polymerization method of the fluororesin (II) is not limited, and examples include bulk polymerization, suspension polymerization, solution polymerization, and emulsion polymerization. In the above polymerizations, various conditions such as temperature and pressure, a polymerization initiator and other additives can be suitably set in accordance with compositions and amounts of a desired fluororesin.

The fluororesin (II) may be subjected to fluorination treatment thereby to prepare the fluororesin having the number of functional groups within the above range.

The fluorination treatment can be carried out by allowing a fluororesin that is not fluorination treated to contact a fluorine-containing compound.

The fluorine-containing compound is not limited, and examples include a fluorine radical source that generates fluorine radical under fluorination treatment conditions. Examples of the fluorine radical source include a $F_2$ gas, $CoF_3$, $AgF_2$, $UF_6$, $OF_2$, $N_2F_2$, $CF_3OF$, and halogen fluoride (for example, $IF_5$, $ClF_3$).

The fluorine radical source such as a $F_2$ gas may have a 100% concentration, but is preferably used, considering handleability, as diluted to 5 to 50% by mass by mixing with an inert gas, and more preferably used as diluted to 15 to 30% by mass. Examples of the inert gas include nitrogen gas, helium gas, and argon gas, but nitrogen gas is economically preferable.

The fluorination treatment conditions are not limited, and a fluororesin in the molten state may be allowed to contact a fluorine-containing compound but the fluorination treatment can be typically carried out at a melting point or less of a fluororesin, preferably at a temperature of 20 to 220°C, and more preferably at a temperature of 100 to 200°C. The fluorination treatment is generally carried out for 1 to 30 hours, and preferably 5 to 25 hours. It is preferable that the fluorination treatment allows a fluororesin that is not fluorination treated to contact a fluorine gas ($F_2$ gas).

The total content of the fluororesins contained in the coating composition of the present disclosure with respect to the whole composition is preferably 30 to 800 by mass, and more preferably 40 to 70% by mass.

The average particle size of the fluororesins contained in the coating composition of the present disclosure is smaller than the average particle size of the powdered fluororesins that have been used in the conventional coating compositions because the fluororesins are contained in the form of the emulsion at polymerization. Specifically, the average particle size is preferably less than 0.3 $\mu$m. The average particle size herein is not limited to the fluororesin (I) or the fluororesin (II) but is the value obtained by measuring particles randomly selected from the fluororesin particles contained in the coating composition and calculating.

Specifically, the average particle size is the value obtained by diluting the coating composition 1,000-fold with water, placing a drop of the diluted liquid on an aluminum foil to dry by itself, taking an SEM (scanning electron microscope) image thereof, measuring particle sizes from image data of 100 particles randomly selected using an SEM image analysis software, and calculating an average.

The average particle size has the lower limit of preferably 0.05 $\mu$m, more preferably 0.07 $\mu$m, and further preferably 0.1 $\mu$m.

The average particle size of the fluororesins is preferably 1/5 or less, and more preferably 1/10 or less, of the average particle size of the anisotropic filler to be described later. An average particle size of 1/5 or less can densely fill in gaps of the anisotropic filler, hence preferable.

(Anisotropic filler)

The coating composition of the present disclosure contains an anisotropic filler. The anisotropic filler, when parallelly oriented to the substrate surface, is preferable in terms of highly expressing the physical properties of the anisotropic filler even when an amount added is comparatively small. The fluororesin fine particles contained in the fluororesin emulsion described above can densely fill in gaps of the anisotropic filler, thereby providing the coating composition having low coefficient of linear expansion at low dielectricity.

Examples of the anisotropic filler include carbon filler, nitride filler, mica filler, clay filler, and talc filler, with a filler containing boron nitride or talc being preferable, and a filler containing talc being more preferable.

The anisotropic filler may be used singly, or 2 or more kinds having different physical properties such as the average particle size or the kind may be used.

The shape of the anisotropic filler may be any of particulate shape, needle shape (fibrous), and plate shape. Examples of specific shape of the anisotropic filler include scaly shape, layer shape, leafy shape, almond shape, columnar shape, crest shape, equiaxed crystal shape, foliate shape, mica shape, block shape, flat-plate shape, wedge shape, rosette shape, network shape, and prism shape. Of these, the shape of the anisotropic filler is preferably scaly shape or plate shape.

When a scaly shape or plate shape anisotropic filler is used, it forms a card-house structure, which not only likely enhances liquid properties (viscosity, dispersion stability, and the like) of the coating composition but also enhances the orientation of the filler in the coating film layer, thereby likely increasing the functions (mechanical strengths, heat conductivity, electrical characteristics, and the like) thereof.

The average particle size of the anisotropic filler is preferably 1 $\mu$m or more and 20 $\mu$m or less. An average particle size within the above range provides better dispersion stability in the coating composition. The average particle size is more preferably 3 to 10 $\mu$m.

In the present disclosure, the average particle size of the anisotropic filler is measured by a dry laser method using a particle size distribution analyzer, HELOS&RODOS (manufactured by SYMPATEC GmbH).

The anisotropic filler used herein means a filler whose aspect ratio is not 1. The anisotropic filler used in the present disclosure preferably has an aspect ratio of 15 or more. An aspect ratio of 15 or more likely further enhances the orientation of the filler in the coating film layer, and likely enhances the functions thereof. Specifically, the dispersion state of the anisotropic filler in the dispersion likely stabilizes, and the orientation of the anisotropic filler much enhances when forming a coating film layer from the coating composition, thereby likely obtaining a laminate highly having physical properties of the fluororesins and physical properties of the anisotropic filler.

The aspect ratio is more preferably 20 or more, and further preferably 30 or more. The upper limit is preferably 100.

The aspect ratio used herein means, on any single particle, the ratio ($d_L/d_S$) of a long diameter ($d_L$) of the longest length of a straight line connecting any 2 points on a particle surface to a short diameter ($d_S$) of the shortest length of a straight line perpendicular to this longest straight line. The aspect ratio herein is the value obtained by image processing.

The anisotropic filler may be subjected to surface treatment. The surface treatment in advance can prevent aggregation of the anisotropic filler and can well disperse the anisotropic filler in the resin composition.

The surface treatment is not limited, and any known treatment can be used. Specifically, examples include treatment using a silane coupling agent such as epoxy silane, aminosilane, vinylsilanes, and acrylic silane having a reactive functional group, hydrophobic alkyl silane, phenylsilane, fluorinated alkyl silane, plasma treatment, and fluorination treatment.

The surface treatment is preferably the treatment using a silane coupling agent, and the reactive functional group of a silane coupling agent is, from the viewpoint of adhesive property to the resin substrate, preferably at least 1 kind selected from an amino group, a (meth)acrylic group, a mercapto group, and an epoxy group, present at an end.

The amount of the anisotropic filler contained with respect to the whole composition is preferably 0.3 to 5% by mass, and more preferably 1 to 3% by mass.

In the coating composition of the present disclosure, the mass ratio of the anisotropic filler to the total amount of the fluororesins is preferably 5:95 to 60:40, and more preferably 20:80 to 35:65. A mass ratio within the above range can balance between the coefficient of linear expansion and the moldability, hence preferable in the point of readily achieving the fluororesin composition having both of these properties.

The coating composition of the present disclosure may further contain other fillers. Other fillers described above preferably include silica, clay, talc, calcium carbonate, mica, diatomaceous earth, alumina, zinc oxide, titanium oxide, calcium oxide, magnesium oxide, iron oxide, tin oxide, antimony oxide, calcium hydroxide, magnesium hydroxide, aluminum hydroxide, basic magnesium carbonate, magnesium carbonate, zinc carbonate, barium carbonate, dawsonite, hydrotalcite, calcium sulfate, barium sulfate, calcium silicate, montmorillonite, bentonite, activated clay, sepiolite, imogolite, sericite, glass fiber, glass bead, silica balloon, carbon black, carbon nanotube, carbon nanohorn, graphite, carbon fiber, glass balloon, carbon balloon, wood powder, and zinc borate.

(Surfactant)

The coating composition of the present disclosure further contains a surfactant. The surfactant, when contained, can enhance the dispersion stability of the coating composition and prevent coating film from cracking. The surfactant is not limited and is preferably a non-fluorosurfactant in the aspect of cost and stability.

The non-fluorosurfactant is not limited as long as it can stably disperse the fluororesins in the composition, and any of anionic surfactants, cationic surfactants, nonionic surfactants, and amphoteric surfactants can be used. Examples include anionic surfactants such as sodium alkylsulfate, sodium alkyl ether sulfate, triethanolamine alkyl sulfate, triethanolamine alkyl ether sulfate, ammonium alkyl sulfate, ammonium alkyl ether sulfate, sodium alkyl ether phosphate, and sodium fluoroalkyl carboxylate; cationic surfactants such as alkylammonium salt, and alkyl benzyl ammonium salt; nonionic surfactants such as polyoxyethylene alkyl ether, polyoxyethylene phenyl ether, polyoxyethylene alkyl ester, propylene glycol-propylene oxide copolymer, perfluoroalkyl ethylene oxide adduct, and 2-ethylhexanol ethylene oxide adduct; and amphoteric surfactants such as alkyl amino acetic acid betaine, alkyl amide acetic acid betaine, and imidazolinium betaine. Of these, anionic and nonionic surfactants are preferable. The surfactant particularly preferable is nonionic surfactants that have an oxyethylene chain with a small pyrolysis residue.

Examples of commercial product of the above nonionic surfactants include Genapol X080 (product name, manufactured by Clariant AG), NOIGEN TDS series (manufactured by DKS Co. Ltd.) as represented by NOIGEN TDS-80 (product name) and NOIGEN TDS-100 (product name), LEOCOL TD series (manufactured by Lion Corporation) represented by LEOCOL TD-90 (product name), LIONOL (registered trademark) TD series (manufactured by Lion Corporation), T-Det A series (manufactured by Harcros Chemicals Inc.) represented by T-Det A138 (product name), TERGITOL (registered trademark) 15S series (manufactured by Dow Inc.), and DISPANOL TOC (product name, manufactured by NOF CORPORATION).

For the above non-fluorosurfactant, hydrocarbon-based surfactants, silicone-based surfactants, and acetylene-based surfactants such as acetylene glycol can also be used. Of these non-fluorosurfactants, one kind may be used, or two or more kinds may be used in combination. It should be noted that nonylphenol-based surfactants are preferably not used.

The amount of the non-fluorosurfactant to be contained with respect to 100% by mass of the total amount of the fluororesins is preferably 0.01 to 50% by mass, more preferably 0.1 to 30% by mass, and further preferably 0.2 to 20% by mass. When an amount of the surfactant added is too small, the fluororesins are not homogeneously dispersed whereby partial floating may be caused. On the other hand, when an amount of the surfactant added is too large, the decomposition residue of the surfactant by sintering increases and thus causes coloring, and additionally heat resistance, non-stickiness, and the like of the coated film deteriorate.

(Liquid medium)

The coating composition of the present disclosure further contains a liquid medium. The liquid medium is not limited but preferably contains water.

Further, the coating composition of the present disclosure preferably contains a water-soluble solvent in combination with water. The water-soluble solvent works to wet the fluororesins, and those with a high boiling point connect the resins when dried after application, and acts as a drying retarder for preventing cracks from being caused. A high boiling point solvent evaporates at a sintering temperature of the fluororesins and thus does not affect the coated film.

Specific examples of the water-soluble solvent include low boiling point organic solvents having a low boiling point of up to 100°C such as methanol, ethanol, isopropanol, sec-butanol, t-butanol, acetone, and methyl ethyl ketone; medium boiling point organic solvents having a boiling point of 100 to 150°C such as methyl cellosolve, and ethyl cellosolve; high boiling point organic solvents having a high boiling point of 150°C or more such as N-methyl-2-pyrrolidone, N,N-dimethylacetamide, 3-butoxy-N,N-dimethylpropanamide, 3-butoxy-N,N-dimethylpropanamide, N,N-dimethylformamide, ethylene glycol, propylene glycol, glycerol, dimethyl carbitol, butyl carbitol, butyl dicarbitol, butyl cellosolve, 1,4-butanediol, diethylene glycol, triethylene glycol, tetraethylene glycol, and diethylene glycol monomethyl ether. These water-soluble solvents may be used in 1 kind, or 2 or more kinds may be used in mixture. For the water-soluble solvent, high boiling point organic solvents are preferable, of which glycol-based solvents are more preferable in the respect of dispersion stability and handleability.

It is preferable that the glycol-based solvent contains at least 1 kind selected from the group consisting of ethylene glycol, diethylene glycol monomethyl ether, glycerol, and butyl carbitol.

The amount of the water-soluble solvent to be contained is preferably 0.5 to 50% by mass, and more preferably 1 to 30% by mass, of the total amount of water. In the case of a low boiling point organic solvent, when an amount contained is too small, air bubble entrainment is likely to be caused, whereas such an amount is too large, the whole composition is caused to be flammable, thereby losing the benefit of being an aqueous dispersion composition. In the case of a medium boiling point organic solvent, when an amount contained is too large, the solvent may remain in the coated film and thereby affect the coating film even after sintering, whereas such an amount is too small, the fluororesins are re-powderized when dried after application and cannot be sintered. In the case of a high boiling point organic solvent, when an amount contained is too large, the solvent may remain in the coated film and thereby affect the coating film even after sintering. It is preferable that the above water-soluble solvent does not remain in the coated film even after the fluororesins are sintered by selecting an easily volatile solvent, or adjusting an amount to be contained. The glycol-based solvent, which does not remain in the coating film after the fluororesins are sintered, can be confirmed when the sintered coating film is scraped off and no weight reduction is found near the boiling point of the glycol-based solvent when measured by TG/DTA.

The coating composition can contain various additive typically added to fluororesin compositions such as a stabilizer, a thickener, a decomposition promoter, a corrosion inhibitor, a preservative, and an antifoaming agent.

The thickener is not limited as long as it thickens a coating material and does not affect coating film properties, but a nonionic emulsion of higher fatty acids is preferable because it forms a three-dimensional network structure with fluororesin particles, enhances the apparent viscosity, and prevents the coating film from cracking. Oleic acid emulsions and octanoic acid emulsions are particularly preferable.

One of the present disclosures is a laminate having a coating film layer formed by applying the above coating composition.

The coating composition can be applied by an application method used for typical coating materials, and examples of the application method include spray coating, roll coating, doctor blade coating, dip (immersion) coating, impregnation coating, spin-flow coating, curtain flow coating, bar coater coating, gravure coating method, MICROGRAVURE coating method, and die coating.

The coating composition, after the above application, is dried and sintered, thereby forming the laminate of the present disclosure. The drying is not limited as long as it is a method capable of removing a liquid medium, and examples include a method of drying, by optionally heating, at room temperature to 130°C for 5 to 30 minutes. The sintering is carried out at a temperature or more of the melting points of the fluororesins, and it is preferable to carry out in the range typically from 200 to 400°C for 10 to 60 minutes. It is preferable that the drying and sintering are carried out under inert gas to prevent the coated metal foil from oxidizing.

The coating film formed by using the coating composition of the present disclosure preferably has a thickness of 2 to 40 $\mu$m after dried and sintered. A coating film within such a range can easily form a good coating film that does not cause any issue of coating film conditions, and further sufficiently demonstrates physical properties required as the coating film. The lower limit is more preferably 3 $\mu$m, and further preferably 5 $\mu$m. The upper limit is more preferably 35 $\mu$m, and further preferably 30 $\mu$m.

The article substrate in the laminate of the present disclosure include metals such as iron, stainless steel, copper, aluminum, and brass; glass products such as glass plate, and woven and non-woven fabrics made of glass fiber; formed articles and coated object made of common and heat resistance resins such as polypropylene, polyoxymethylene, polyimide, modified polyimide, polyamidimide, polysulfone, polyether sulfone, polyether ether ketone, and liquid crystal polymer; formed articles and coated object made of common rubbers such as SBR, butyl rubber, NBR, and EPDM, and made of heat resistant rubber such as silicone rubber, and fluoroelastomer; and woven and non-woven fabrics made of natural fiber and synthetic fiber; and laminated substrates formed by combinations thereof.

The article substrate may be surface processed. Examples of the surface process include roughening the surface to a desired degree of roughness using a sandblaster, roughening the surface by adhering particles thereto, and treating the surface for preventing metal oxidation.

The coating composition of the present disclosure can enhance adhesive properties to the substrate.

Specifically, the adhesion strength between the coating film layer formed by applying the coating composition of the present disclosure and the article substrate can be 3 N/cm or more.

The adhesion strength is the value obtained by superposing the laminate consisting of the coating film layer and the substrate so that the coating film layer adheres firmly to a copper foil, pressing for 5 minutes at a heating temperature under vacuum: 320°C and a pressure: 3 MPa, thereby obtaining a bonded body on which the laminate consisting of the coating film layer and the substrate and the copper foil are laminated, and then cutting the bonded body to strip shape of width 10 mm × length 40 mm × 3 sets to prepare test pieces, subjecting these test pieces to a 90-degree peel test using an autograph (manufactured by SHIMADZU CORPORATION, AGS-J 5kN) in conformity with JIS C 6481-1996, at 25°C and a tensile speed of 50 mm/min, observing and measuring a delamination mode.

The above adhesion strength is more preferably 5 N/cm or more.

The adhesion strength varies depending on the kind of substrate even when the coating composition used is the same, but the coating composition of the present disclosure is particularly preferable in the respect of obtaining excellent peel strength as described above even when a substrate, which is typically difficult to obtain a peel strength, is used.

More specifically, even when the article substrate is a metal substrate having a small surface roughness, an adhesion strength in the range described above can be obtained. For example, when a copper foil having a surface roughness (Rz) of 2.0 $\mu$m or less is used as the substrate, the conventional fluorine-containing coating composition failed to obtain sufficient adhesive properties, but the coating film layer made of the coating composition of the present disclosure can demonstrate an adhesion strength of 3 N/cm or more.

The surface roughness (Rz) refers to ten-point average roughness stipulated in JIS-B0601. In the present description, the above Rz is the value measured by using a surface texture and contour measuring instrument (product name: SURFCOM 470A, manufactured by TOKYO SEIKI KOSAKUSHO Co., Ltd) with a measurement length of 4 mm.

The laminate of the present disclosure can be used in the fields in which heat resistance, solvent resistance, lubricity, non-stickiness, and the like are required, and used for films, fiber reinforced films, prepregs, resin coated metal foils, metal-clad laminates, printed circuit boards, dielectric materials for circuit boards, laminated circuit boards, and the like.

It is particularly preferable that the laminate of the present disclosure has the coating film layer formed by the coating composition of the present disclosure on a copper foil. In recent years, communications in high frequency ranges have been increasing in various fields. For the reduction of a transmission loss when used in high frequency ranges, a laminate in which a fluoropolymer-containing dielectric layer and a copper foil are laminated has been used. The coating composition of the present disclosure can be used particularly preferably in such a usage.

Examples

Hereinafter, the present invention will be described with reference to examples. In the examples, % and part in the containing proportion mean % by mass and parts by mass unless otherwise specified. The present invention is not limited to the examples described below.

Production Example 1

(PTFE Emulsion)

A PTFE emulsion used had a polymer solid content concentration of 64% by mass, a nonionic surfactant concentration of 2.7% by mass with respect to a polytetrafluoroethylene solid content, an average particle size of 312 nm, a standard specific gravity of 1.57, and the number of functional groups measured by the method described above of 10 or less per $10^6$ main-chain carbon atoms.

Production Example 2

(Preparation of PFA-1)

An aqueous dispersion of PFA was obtained by the method described in Example 4 of Japanese Patent No. 4306072. The obtained PFA particles had an average particle size of 194 nm, and the number of functional groups was 143 per $10^6$ main-chain carbon atoms.

Production Example 3

(Preparation of FEP-1)

An aqueous dispersion of FEP was obtained by the method described in Example 1 of Japanese Patent No. 4306072. FEP particles contain carboxylic acid derived from an initiator in an end group, and the obtained functional group-containing FEP particles had an average particle size of 65 nm, and the number of functional groups measured by the method described above was 207 per $10^6$ main-chain carbon atoms.

Production Example 4

(Preparation of PFA-2)

A tetrafluoroethylene (TFE)/perfluoro vinyl ether (PFVE) copolymer (PFA: melting point=300°C, MFR=25 g/10 min) was produced by suspension polymerization, and the obtained dry powder was crushed directly using an air jet mill apparatus (manufactured by I. M. MATERIAL Corporation), thereby to obtain a fine powder having an average particle size of 2.5 $\mu$m. With respect to 100 parts by mass of the PFA fine powder, 10 parts by mass of an acetylene glycol-based dispersant (SURFYNOL 440, manufactured by Air Products Japan, K.K.), 10 parts by mass of a nonionic surfactant (NOIGEN TDS-80, manufactured by DKS Co. Ltd.) and 280 parts by mass of deionized water were sufficiently stirred and mixed with the PFA fine powder, thereby to obtain a PFA dispersion. The number of functional groups of the obtained PFA particles was 10 or less per $10^6$ main-chain carbon atoms.

Production Example 5

(Preparation of FEP-2)

Using a polymerization initiator (di(ω-hydroperfluorohexanoyl)peroxide), TFE and HFP were subjected to suspension polymerization to produce FEP (TFE/HFP=90/10 molar ratio), and the obtained dry powder was crushed directly using an air jet mill apparatus (manufactured by I. M. MATERIAL Corporation), thereby to obtain a fine powder having an average particle size of 10 $\mu$m. With respect to 100 parts by mass of the obtained FEP fine powder, 10 parts by mass of an acetylene glycol-based dispersant (SURFYNOL 440, manufactured by Air Products Japan, K.K.), 10 parts by mass of a silicone-based surfactant (KP-106, manufactured by Shin-Etsu Chemical Co., Ltd.) and 280 parts by mass of deionized water were sufficiently stirred and mixed with the FEP fine powder, thereby to obtain an FEP dispersion. The number of functional groups of the obtained FEP particles measured by the method described above was 20 per $10^6$ main-chain carbon atoms.

Production Example 6

(Production of an anisotropic filler dispersion)

An anisotropic filler dispersion was produced by mixing anisotropic fillers, water, and a surfactant (LEOCOL TD-90D, a hydrocarbon nonionic surfactant, manufactured by LION SPECIALTY CHEMICALS CO., LTD.), and then dispersing the anisotropic filler in water using Star Burst Labo (manufactured by Sugino Machine Limited).
The anisotropic fillers used are as follows. Talc is all manufactured by Nippon Talc Co., Ltd. Boron nitride is manufactured by Denka Company Limited.
Additionally, for a comparative example, a spherical silica dispersion 5SQ-CW (manufactured by ADMATECHS COMPANY LIMITED) was used.

[Table 2]

| | Product number | Average particle size ($\mu$m) | Aspect ratio |
|---|---|---|---|
| Talc 1 | PAOG-2 | 7.0 | 45 |
| Talc 2 | PAOG-3 | 5.0 | 40 |
| Talc 3 | P-4 | 4.5 | 30 |
| Talc 4 | P-3 | 5.0 | 30 |
| Talc 5 | P-2 | 7.0 | 30 |
| Talc 6 | PAOG-2/P-3=50/50 | 6.0 | 30 |
| Talc 7 | PAOG-3/P-2=50/50 | 6.0 | 30 |
| BN1 | Denka Company Limited SP-3 | 4.0 | 20 |

Examples 1 to 16, Comparative Examples 1 to 6

Each of the obtained fluororesin emulsions and anisotropic filler dispersions were mixed so as to have the amounts contained shown in Tables 3 to 5, thereby obtaining the coating compositions.
The average particle sizes of the fluororesins contained in the obtained coating compositions were measured by the method described above. The average particle size of the fluororesins contained in the coating composition of Comparative Example 2 was difficult to measure in the same screen because the fluororesins in combination had significantly different average particle sizes.
Coating film layer was obtained in accordance with the following method.
The coating material was applied onto a copper foil (manufactured by FUKUDA METAL FOIL & POWDER CO., LTD. CF-V9S-SV-18, surface roughness 0.8 $\mu$m (Rz)) using a bar coater (No. 30). The copper foil after application was dried at 130°C for 15 minutes. Further, the copper foil was sintered under nitrogen gas atmosphere at 350°C for 15 minutes, thereby to produce a coating film having a film thickness of 25 $\mu$m.
Further, the obtained coating film was evaluated based on the following criteria.

(Linear expansion of a coating film layer)

A copper foil was etched, and only a coating film layer was taken out to measure linear expansion using Thermo Mechanical Analyzers (TMA/TMA7100E; manufactured by Hitachi Hi-Tech Analytical Science). The linear expansion was the value measured within a temperature range from -55°C to -280°C. The X/Y axis direction was measured in Expansion mode, and the Z axis direction was measured in Compression mode.

(Coating film defect: cracks when dried)

Using a laser microscope (manufactured by Keyence Corporation), the coating film after dried was observed under a 5x objective lens to observe the presence or absence of cracks in the coating film.

No crack found: Good
Cracks found in part: Fair
Cracks found all over: Poor

(Coating film defect: holes after sintered)

Using a laser microscope (manufactured by Keyence Corporation), the coating film after sintered was observed under a 5x objective lens to observe the presence or absence of a defect of holes in the coating film.

No hole found: Good
Holes found: Poor

(Adhesion strength between the copper foil and coating film layer)

The adhesion strength was measured by superposing a laminate consisting of the coating film layer and the substrate so that the coating film layer adheres firmly to a copper foil, pressing for 5 minutes at a heating temperature: 320°C and a pressure: 3 MPa, thereby obtaining a bonded body on which the laminate consisting of the coating film layer and the substrate and the copper foil were laminated, and then cutting the bonded body to strip shape of width 10 mm $\times$ length 40 mm $\times$ 3 sets to prepare test pieces, subjecting these test pieces to a peel test using an autograph (manufactured by SHIMADZU CORPORATION, AGS-J 5kN) in conformity with JIS C 6481-1996, at 25°C and a tensile speed of 50 mm/min, and observing a delamination mode.

3N/cm or more: Good
Less than 3N/cm: Poor

(Dielectric constant, dielectric dissipation factor)

The dielectric constant and the dielectric dissipation factor were measured at 10 GHz using a cavity resonator (manufactured by Kanto Electronics Application & Development Inc.) and analyzed using a network analyzer (manufactured by Agilent Technologies, Inc.).
The dielectric constant was evaluated based on the following criteria.

3.5 or less: Good
More than 3.5: Poor

Further, the dielectric dissipation factor was evaluated based on the following criteria.
0.0015 or less: Good
More than 0.0015: Poor

[Table 3]

| | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|
| Fluororesin ratio | PTFE | 65 | 65 | 65 | 65 | 65 | 65 | 65 | 65 | 65 | 65 | 65 |
| | PFA-1 | 0 | 0 | 0 | 0 | 0 | 0 | 0 | 0 | 0 | 35 | 35 |
| | FEP-1 | 35 | 35 | 35 | 35 | 35 | 35 | 35 | 35 | 35 | 0 | 0 |
| Fluororesin:Filler | | 60:40 | 60:40 | 70:30 | 60:40 | 60:40 | 60:40 | 60:40 | 60:40 | 60:40 | 70:30 | 60:40 |
| Filer type | | Talc 1 | Talc 1 | Talc 2 | Talc 2 | Talc 3 | Talc 4 | Talc 5 | Talc 6 | Talc 7 | Talc 2 | BN1 |
| Average particle size of flucroresins ($\mu$m) | | 0.20 | 0.20 | 0.20 | 0.20 | 0.20 | 0.20 | 0.20 | 0.20 | 0.20 | 0.28 | 0.28 |
| Coefficient of linear expansion | | 87.7 | 82.2 | 90.0 | 63.6 | 77.6 | 70 | 72.8 | 81.6 | 86.3 | 88.2 | 95.2 |
| Coating film defect (crack when dried) | | Good | Good | Good | Good | Good | Good | Good | Good | Good | Good | Good |
| Coating film defect (hole after sintered) | | Good | Good | Good | Good | Good | Good | Good | Good | Good | Good | Good |
| Adhesion to copper foil | | Good | Good | Good | Good | Good | Good | Good | Good | Good | Good | Good |
| Dielectric constant | | Good | Good | Good | Good | Good | Good | Good | Good | Good | Good | Good |
| Dielectric dissipation factor | | Good | Good | Good | Good | Good | Good | Good | Good | Good | Good | Good |

[Table 4]

| | | Comparative Example 1 | Comparative Example 2 | Comparative Example 3 | Comparative Example 4 | Comparative Example 5 | Comparative Example 6 |
|---|---|---|---|---|---|---|---|
| Fluororesin ratio | PTFE | 65 | 65 | 65 | 100 | 0 | 0 |
| | FEP-1 | 35 | 0 | 0 | 0 | 100 | 0 |
| | FEP-2 | 0 | 35 | 0 | 0 | 0 | 0 |
| | PFA-2 | 0 | 0 | 35 | 0 | 0 | 100 |
| Fluororesin:Filler | | 60:40 | 60:40 | 60:40 | 60:40 | 60:40 | 60:40 |
| Filler type | | Spherical silica | Talc 1 | Talc 1 | Talc 1 | Talc 1 | Talc 1 |
| Average particle size of fluororesins ($\mu$m) | | 0.20 | Unmeasurable | 1.20 | 0.27 | 0.10 | 250 |
| Coefficient of linear expansion | | 180 | 95 | 110 | 95 | Unmeasurable | Unmeasurable |
| Coating film defect (crack when dried) | | Good | Good | Good | Good | Poor | Poor |
| Coating film defect (hole after sintered) | | Good | Good | Poor | Good | Poor | Poor |
| Adhesion to copper foil | | Good | Poor | Poor | Poor | Good | Good |
| Dielectric constant | | Good | Good | Good | Good | Not measured | Good |
| Dielectric dissipation factor | | Good | Good | Good | Good | Poor | Poor |

It is revealed that the coating composition of the present disclosure is free of coating film defects and has sufficient performance as an insulating material.

Industrial Applicability

The coating composition of the present disclosure can be suitably used as the insulating material for a circuit board.

**Claims**

1. A coating composition comprising 2 or more kinds of fluororesin emulsions, wherein

    at least 1 kind of the fluororesin, a fluororesin (I), has a number of functional groups of 30 to 1,000 per $10^6$ main-chain carbon atoms, and
    the coating composition further comprises an anisotropic filler, a surfactant, and a liquid medium.

2. The coating composition according to claim 1,
   wherein the functional group contained in the fluororesin (I) is a carbonyl group-containing group.

3. The coating composition according to claim 2,
   wherein the carbonyl group-containing group is at least 1 group selected from the group consisting of a carbonyl amide group, a carboxy group, an acyl fluoride group, and a methoxycarbonyl group.

4. The coating composition according to any of claims 1 to 3, wherein the functional group contained in the fluororesin (I) is present at an end of the polymer main chain.

5. The coating composition according to any of claims 1 to 4, wherein the fluororesin (I) is a tetrafluoroethylene-hexafluoropropylene copolymer (FEP) or a tetrafluoroethylene-perfluoroalkyl vinyl ether copolymer (PFA).

6. The coating composition according to any of claims 1 to 5, wherein at least 1 kind of the fluororesin, a fluororesin (II), has a number of functional groups of less than 30 per $10^6$ main-chain carbon atoms.

7. The coating composition according to claim 6,
   wherein the fluororesin (II) is PTFE.

8. The coating composition according to claim 7,
   wherein an average particle size of PTFE is 0.1 to 0.5 $\mu$m.

9. The coating composition according to claim 7 or 8,
   wherein a content of PTFE with respect to all fluororesins amount is 50% by mass or more.

10. The coating composition according to any of claims 1 to 9, wherein an average particle size of the fluororesins is 1/5 or less of an average particle size of the anisotropic filler.

11. The coating composition according to any of claims 1 to 10, wherein an average particle size of the fluororesins is less than 0.3 $\mu$m.

12. The coating composition according to any of claims 1 to 11, wherein the anisotropic filler is boron nitride or talc.

13. The coating composition according to any of claims 1 to 12, wherein the anisotropic filler has an aspect ratio of 15 or more.

14. The coating composition according to any of claims 1 to 13, wherein a mass ratio of the anisotropic filler to a total amount of the fluororesins is 5:95 to 60:40.

15. The coating composition according to any of claims 1 to 14, wherein the surfactant is a non-fluorosurfactant.

**16.** The coating composition according to any of claims 1 to 15, wherein the liquid medium contains water.

**17.** An insulating material for a circuit board comprising the coating composition according to any of claims 1 to 16.

**18.** A laminate having a coating film layer formed by applying the coating composition according to any of claims 1 to 16 onto a substrate.

**19.** The laminate according to claim 18, wherein the substrate is a metal material.

**20.** The laminate according to claim 19, wherein the metal material has a surface roughness Rz of 2.0 $\mu$m or less on a surface of the coating film layer side.

**21.** The laminate according to claim 19 or 20, wherein the metal is copper.

**22.** The laminate according to any of claims 18 to 21, which is a printed circuit board, a dielectric material for a circuit board, or a laminated circuit board.

## INTERNATIONAL SEARCH REPORT

| International application No. |
|---|
| **PCT/JP2023/014045** |

### A. CLASSIFICATION OF SUBJECT MATTER

*C09D 5/02*(2006.01)i; *C09D 127/12*(2006.01)i; *C09D 201/04*(2006.01)i; *C09D 7/47*(2018.01)i; *C09D 7/61*(2018.01)i
FI:   C09D201/04; C09D127/12; C09D7/61; C09D7/47; C09D5/02

According to International Patent Classification (IPC) or to both national classification and IPC

### B. FIELDS SEARCHED

Minimum documentation searched (classification system followed by classification symbols)

C09D5/02; C09D127/12; C09D201/04; C09D7/47; C09D7/61

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2016-87799 A (DU PONT-TORAY CO., LTD.) 23 May 2016 (2016-05-23)<br>entire text, all drawings | 1-22 |
| A | WO 2004/039883 A1 (DAIKIN INDUSTRIES, LTD.) 13 May 2004 (2004-05-13)<br>entire text, all drawings | 1-22 |
| A | JP 2001-207005 A (DAIKIN INDUSTRIES, LTD.) 31 July 2001 (2001-07-31)<br>entire text, all drawings | 1-22 |

☐ Further documents are listed in the continuation of Box C.     ☑ See patent family annex.

| | |
|---|---|
| \* Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **16 June 2023** | **27 June 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/014045**

| Patent document cited in search report | | | Publication date (day/month/year) | Patent family member(s) | | | Publication date (day/month/year) |
|---|---|---|---|---|---|---|---|
| JP | 2016-87799 | A | 23 May 2016 | (Family: none) | | | |
| WO | 2004/039883 | A1 | 13 May 2004 | US | 2006/0035047 | A1 | |
| | | | | entire text, all drawings | | | |
| | | | | EP | 1561784 | A1 | |
| JP | 2001-207005 | A | 31 July 2001 | (Family: none) | | | |

Form PCT/ISA/210 (patent family annex) (January 2015)

**REFERENCES CITED IN THE DESCRIPTION**

**Patent documents cited in the description**

- WO 2021112164 A
- JP 2021121675 A
- WO 2020145133 A
- JP 2015040296 A
- JP 4306072 B